# EUROPÄISCHE PATENTSCHRIFT

(11) **EP 3 826 875 B1**
(45) Veröffentlichungstag und Bekanntmachung des Hinweises auf die Patenterteilung: **05.07.2023**
(21) Anmeldenummer: 19735522.5
(22) Anmeldetag: 27.06.2019
(51) Int. Cl.: B60K 35/00, G09G 3/00, G01R 31/44, G01R 31/26, B60Q 9/00, B60R 16/023, B60W 50/04, B60W 50/14, G01R 31/00, G06Q 10/00, G07C 5/00, G07C 5/08, H04L 1/00, B60W 50/00, B60W 50/029

(54) **SYSTEM ZUR AUTOMATISCH ÜBERWACHTEN FAHRZEUGZUSTANDSSIGNALISIERUNG UND VERFAHREN ZUR ÜBERWACHUNG EINER FAHRZEUGZUSTANDSSIGNALISIERUNGSVORRICHTUNG**
SYSTEM FOR AUTOMATICALLY MONITORED VEHICLE STATUS SIGNALLING AND METHOD FOR MONITORING A VEHICLE STATUS SIGNALLING DEVICE
SYSTÈME DE SURVEILLANCE AUTOMATIQUE DE LA SIGNALISATION DE L'ÉTAT DU VÉHICULE ET PROCÉDÉ DE SURVEILLANCE D'UN DISPOSITIF DE SIGNALISATION DE L'ÉTAT DU VÉHICULE

(30) Priorität: 26.07.2018 DE 102018118057
(43) Veröffentlichungstag der Anmeldung: 02.06.2021
(73) Patentinhaber: Valeo Schalter und Sensoren GmbH, 74321 Bietigheim-Bissingen (DE)
(72) Erfinder: STAUDE, Sascha, 74321 Bietigheim-Bissingen (DE); MACK, Raphael, 74321 Bietigheim-Bissingen (DE); DIETZ, Benjamin, 74321 Bietigheim-Bissingen (DE); TANDJEU TCHUISSI, Landry, 74321 Bietigheim-Bissingen (DE)
(74) Vertreter: Pothmann, Karsten
(86) Internationale Anmeldenummer: PCT/EP2019/067169
(87) Internationale Veröffentlichungsnummer: WO 2020/020566

(56) Entgegenhaltungen:
- EP-A1- 3 090 911
- DE-A1-102016 217 518
- US-A1- 2015 142 386

## Beschreibung

Die vorliegende Erfindung betrifft ein System zur überwachten Fahrzeugzustandssignalisierung, insbesondere zur überwachten Signalisierung eines aktivierten zumindest teilautomatisierten Fahrbetriebszustands eines Kraftfahrzeugs. Speziell betrifft die Erfindung als selbstständige Teilaspekte des Systems auch eine Überwachungsvorrichtung zur Durchführung des Verfahrens, sowie ein mit dem System ausgerüstetes Fahrzeug, insbesondere Kraftfahrzeug.

Aus dem Stand der Technik ist die DE 10 2016 217 518 A1 bekannt. Dieses Dokument betrifft ein Verfahren zur Überwachung einer Nichtanzeige eines vorgegebenen Bildes, insbesondere eines Symbols, in einem Display einer Anzeigevorrichtung, insbesondere für ein Kraftfahrzeug, wobei Bilddaten überwacht werden, die einer vorgegebenen Menge von Bildpunkten des Displays zugeordnet sind, wobei für jeden Bildpunkt der Menge bestimmt wird, ob eine Abweichung eines Farbwerts der dem Bildpunkt zugeordneten Bilddaten von einem Sollfarbwert des vorgegebenen Bildes für den Bildpunkt einen vorgegebenen ersten Grenzwert überschreitet, wobei auf die Nichtanzeige des vorgegebenen Bildes erkannt wird, wenn eine Gesamtabweichung, welche auf den den ersten Grenzwert überschreitenden Abweichungen basiert, einen vorgegebenen zweiten Grenzwert überschreitet.

Die EP 3 090 911 A1 offenbart ein Warnsystem, das umfasst: eine Warnvorrichtung; eine Anzeigevorrichtung; eine IC-CPU zum Steuern des Betriebs der Anzeigevorrichtung und der Warnvorrichtung; und eine Master-ECU, um, verbunden mit der IC-CPU über einen Kommunikationskanal und verbunden mit einer oder mehreren Warnvorrichtungen über einen Hardwarekanal, den Betrieb der Warnvorrichtung durch die IC-CPU zu steuern. Die Master-ECU umfasst ein Fehlererkennungsmodul zum regelmäßigen Überwachen der Datengültigkeit des Kommunikationskanals, der Warnvorrichtung und der Reaktion der IC-CPU, und ein Ein/Aus-Modul zum Betreiben der Warnvorrichtung. Wenn das Fehlererkennungsmodul einen Fehler in der Datengültigkeit des Kommunikationskanals, der Warnvorrichtung und der Reaktion der IC-CPU erkennt, steuert die Master-ECU das Ein/Aus-Modul, um die Warnvorrichtung unter Verwendung des Hardwarekanals direkt zu betreiben.

Die US 2015/142386 A1 offenbart einen Funktionsmonitor für ein System, wie beispielsweise ein Fahrerassistenzsystem, umfassend ein erstes Funktionsüberwachungselement und ein zweites Funktionsüberwachungselement, wobei das erste Funktionsüberwachungselement konfiguriert ist, um Sensordaten von einer Vielzahl von Sensoren, die dem System zugeordnet sind, zu empfangen und zu sammeln und Senden eines Funktionswarnsignals an das zweite Funktionsüberwachungselement, wenn die Sensordaten von einem oder mehreren der Vielzahl von Sensoren eine Funktionsunregelmäßigkeit anzeigen.

In der Fahrzeugtechnik, insbesondere der Kraftfahrzeugtechnik, werden regelmäßig verschiedenste Signalisierungselemente, insbesondere Anzeigeelemente, wie etwa Leuchtmittel oder Bildschirme, eingesetzt, um bestimmte Fahrzeugzustände einem Nutzer des Fahrzeugs, insbesondere dessen Fahrer, gegenüber zu signalisieren. Solche Leuchtmittel können insbesondere Leuchtdioden sein oder enthalten. Neben solchen optischen Signalisierungen sind alternativ oder zusätzlich auch akustische Signalisierungen regelmäßig anzutreffen, etwa zur Signalisierung der Aktivität eines Richtungsanzeigers (Blinker). Man kann dabei zwischen sicherheitsrelevanten und nicht sicherheitsrelevanten Signalisierungen unterscheiden. So ist beispielsweise eine Signalisierung der Aktivität einer Klimaanlage für den Fahrgastraum eines Fahrzeugs in der Regel als nicht sicherheitsrelevant einzustufen, während die Signalisierung des Aktivierungszustands einer Handbremse oder aber eines zumindest teilautomatisierten Fahrmodus des Fahrzeugs an den Fahrer regelmäßig als sicherheitsrelevant einzustufen sind. Eine solche Einstufung einer Signalisierung eines Fahrzeugzustands, wie etwa eines Fahrbetriebsmodus, als sicherheitsrelevant kann insbesondere auch gesetzlich festgelegt sein.

Vor allem bei den sicherheitsrelevanten Signalisierungen kann zudem im Hinblick auf aktivierbare und deaktivierbare Funktionalitäten bzw. Zustände eines Fahrzeugs eine weitere Unterscheidung dahingehend getroffen werden, ob der aktivierte oder der deaktivierte Zustand beziehungsweise eine entsprechende Signalisierung des aktiven beziehungsweise deaktivierten Zustands der entsprechenden Signalisierung als sicherheitskritisch einzustufen ist. So gehört beispielsweise ein Bremslicht typischerweise zu einer ersten Fallgruppe, bei der es im Sinne der Sicherheit als kritisch anzusehen ist, wenn die Signalisierung (Bremslicht leuchtet) nicht erfolgt, obwohl sie aufgrund eines aktuellen Fahrzeugzustands (laufender Bremsvorgang) leuchten sollte. Der aktivierte Zustand des Bremslichts ist regelmäßig als sicherheitskritisch einzustufen, da ein Ausfall des Bremslichts ein Sicherheitsrisiko, insbesondere im Hinblick auf die Gefahr eines Auffahrunfalls, darstellt. Der deaktivierte, d. h. ausgeschaltete Zustand des Bremslichts, ist dagegen typischerweise nicht, jedenfalls nicht gleichermaßen, als sicherheitskritisch einzustufen.

Daneben ist jedoch auch noch eine zweite Fallgruppe denkbar, die den umgekehrten Fall betrifft, bei dem es im Sinne der Sicherheit als kritisch anzusehen ist, wenn die Signalisierung erfolgt, obwohl sie aufgrund eines aktuellen Fahrzeugzustands nicht erfolgen sollte. Die vorliegende Erfindung betrifft diese zweite Fallgruppe und ihr liegt die Aufgabe zugrunde, die Sicherheit einer solchen Fahrzeugzustandssignalisierung weiter zu verbessern. Die Lösung dieser Aufgabe wird gemäß der Lehre der unabhängigen Ansprüche erreicht. Verschiedene Ausführungsformen und Weiterbildungen der Erfindung sind Gegenstand der Unteransprüche.

Ein erster Aspekt betrifft ein Verfahren zum automatischen Überwachen einer Fahrzeugzustandssignalisierungsvorrichtung, insbesondere einer Vorrichtung zur Signalisierung eines aktivierten zumindest teilautomatisierten Fahrbetriebszustands eines Kraftfahrzeugs. Das Verfahren weist auf: (i) Übermitteln eines ersten Steuersignals an die Fahrzeugzustandssignalisierungsvorrichtung, das konfiguriert ist, einen zugeordneten Signalgeber der Fahrzeugzustandssignalisierungsvorrichtung in einen deaktivierten Zustand zu versetzen; (ii) nachfolgendes Prüfen eines aktuellen tatsächlichen Betriebszustands des Signalgebers; und (iii) falls die Prüfung ergibt, dass sich der Signalgeber trotz des übermittelten Steuersignals in einem aktivierten Betriebszustand befindet, Auslösen zumindest einer vorbestimmten und der Prüfung zugeordneten Fehlerbegegnungsaktion.

Mittels des Verfahrens wird somit zunächst anhand des ersten Steuersignals der Soll-Betriebszustand des Signalgebers auf "deaktiviert" gesetzt, sodass er nachfolgend nicht mehr aktiv sein sollte, d. h. keine Signalisierung ausgeben sollte. Es sind jedoch Fehlerfälle vorstellbar, etwa Kurzschlüsse, Fehlfunktionen von Schaltern oder Signalunterbrechungen bezüglich von Steuersignalen, die dazu führen, dass tatsächlich der Signalgeber trotz Aussendung des ersten Steuersignals weiterhin aktiv ist, d. h. eine zugehörige Signalisierung ausführt. Derartige Fehlerfälle sind mittels der Prüfung des tatsächlichen Betriebszustands, der im Fehlerfall von dem mittels des ersten Steuersignals angeforderten Betriebszustand abweichen kann, erkennbar, sodass in Reaktion auf das Erkennen eines Fehlerfalls die zugeordnete Fehlerbegegnungsaktion ausgelöst werden kann, um die sicherheitskritische Situation zu entschärfen. Insgesamt leistet das Verfahren somit eine automatische Überwachung der Fahrzeugzustandssignalisierungsvorrichtung bezüglich des Falls, dass die Signalisierung erfolgt, obwohl sie aufgrund eines zugeordneten aktuellen Fahrzeugzustands gegenwärtig nicht erfolgen sollte. Auf diese Weise kann mittels der verfahrensgemäß im erkannten Fehlerfall ausgelösten Fehlerbegegnungsaktion eine Verbesserung der Sicherheit der entsprechenden Fahrzeugzustandssignalisierung erreicht werden.

Unter einer "Fahrzeugzustandssignalisierungsvorrichtung" im Sinne der Erfindung ist eine Vorrichtung zu verstehen, die eingerichtet ist, einen Zustand eines zugeordneten Fahrzeugs mittels einer Mensch-Maschine-Schnittstelle an einen Benutzer des Fahrzeugs, insbesondere dessen Fahrer, zu signalisieren. Die Signalisierung kann dabei mittels eines entsprechenden Signalgebers insbesondere optisch, akustisch und/oder haptisch erfolgen. Beispielsweise kann die Signalisierung über zumindest ein Leuchtmittel als Signalgeber, wie etwa eine Leuchtdiode, oder auch über eine Meldung auf einem Bildschirm, gegebenenfalls mittels zusätzlicher Tonsignalisierung über eine Lautsprecher als Signalgeber, erfolgen. Der signalisierte Zustand des Fahrzeugs kann sich insbesondere auch auf einen Betriebsmodus des Fahrzeugs beziehen. Ein solcher Betriebsmodus kann insbesondere ein teilautomatisierter, hochautomatisierter oder gar autonomer Fahrbetriebszustand eines entsprechend automatisierten Fahrzeugs sein. Zur Erfassung des zu signalisierenden Fahrzeugzustands kann die Fahrzeugzustandssignalisierungsvorrichtung entweder selbst über eine entsprechende Sensorik oder aber über einen Signaleingang verfügen, über den sie ein entsprechendes Signal erhält, welches den zu signalisierenden Fahrzeugzustand kennzeichnet. Ein solches Signal kann insbesondere von einem Steuergerät des Fahrzeugs empfangen werden.

Unter dem " Prüfen eines aktuellen tatsächlichen Betriebszustands des Signalgebers" ist im Sinne der Erfindung insbesondere eine mit technischen Mitteln, insbesondere einer Messung, bewirkte Prüfung dahingehend zu verstehen, ob der Signalgeber zum betrachteten Zeitpunkt aktiviert ist und dementsprechend die ihm in Abhängigkeit vom zugehörigen Fahrzeugzustand zugeordnete Signalisierung ausgibt oder aber unter Wegfall des Signals deaktiviert ist, d.h. sich in einem deaktivierten Zustand befindet, in dem er die Signalisierung nicht ausgibt. Der deaktivierte Zustand kann dabei insbesondere einem vollständig ausgeschalteten Zustand entsprechen, oder aber einem Ruhezustand entsprechen, in dem der Signalgeber zwar Energie versorgt wird, aber die Signalisierung, beispielsweise ein Leuchtsignal, mangels entsprechender Ansteuerung gegenwärtig nicht ausgibt. Er kann insbesondere auch ein besonderer Diagnosezustand sein, der speziell zur Durchführung des Prüfschritts genutzt wird.

Unter "versetzen" des Signalgebers in einen deaktivierten Zustand im Sinne der Erfindung, was insbesondere mittels eines entsprechenden in dem ersten Steuersignal enthaltenen Befehl oder Schaltsignal erfolgen kann, ist insbesondere auch der Fall zu verstehen, dass ein bereits vorliegender deaktivierter Zustand beibehalten wird. Das Versetzen des Signalgebers in den deaktivierten Zustand kann insbesondere direkt, d.h. durch eine entsprechende Beeinflussung des Signalgebers selbst, oder mittelbar durch Beeinflussung einer entsprechenden Ansteuerung des Signalgebers erfolgen.

Unter einer "Fehlerbegegnungsaktion" im Sinne der Erfindung ist eine Aktion der Fahrzeugzustandssignalisierungsvorrichtung selbst und/oder einer damit signalverbundenen weiteren Vorrichtung zu verstehen, die dazu vorgesehen und geeignet ist, nach ihrer Auslösung unmittelbar oder mittelbar als Gegenmaßnahme zu dem mittels der Prüfung erkannten Fehler zu bewirken. Eine Fehlerbegegnungsaktion kann dementsprechend entweder automatisch wirken, um negative Auswirkungen des Fehlers zu beseitigen oder zumindest zu mindern, oder sie kann sich darauf beschränken, einen menschlichen Benutzer dazu einzubinden, etwa wenn sie das Ausgeben einer entsprechenden Warnmeldung oder Handlungsaufforderung an den Benutzer umfasst.

Mittels des Verfahrens wird somit zunächst anhand des ersten Steuersignals der Soll-Betriebszustand des Signalgebers auf "deaktiviert" gesetzt, sodass er nachfolgend nicht mehr aktiv sein sollte, d. h. keine Signalisierung ausgeben sollte. Es sind jedoch Fehlerfälle vorstellbar, etwa Kurzschlüsse, Fehlfunktionen von Schaltern oder Signalunterbrechungen bezüglich von Steuersignalen, die dazu führen, dass tatsächlich der Signalgeber trotz Aussendung des ersten Steuersignals weiterhin aktiv ist, d. h. eine zugehörige Signalisierung ausführt. Derartige Fehlerfälle sind mittels der Prüfung des tatsächlichen Betriebszustands erkennbar, der im Fehlerfall von dem mittels des ersten Steuersignals angeforderten Betriebszustand abweichen kann, sodass in Reaktion auf das Erkennen eines Fehlerfalls die zugeordnete Fehlerbegegnungsaktion ausgelöst werden kann, um die sicherheitskritische Situation zu entschärfen. Insgesamt leistet das Verfahren somit eine automatische Überwachung der Fahrzeugzustandssignalisierungsvorrichtung bezüglich des Falls, dass die Signalisierung erfolgt, obwohl sie aufgrund eines zugeordneten aktuellen Fahrzeugzustands gegenwärtig nicht erfolgen sollte. Auf diese Weise kann mittels der verfahrensgemäß im erkannten Fehlerfall ausgelösten Fehlerbegegnungsaktion eine Verbesserung der Sicherheit der entsprechenden Fahrzeugzustandssignalisierung erreicht werden.

Bei einigen Ausführungsformen umfasst die Fehlerbegegnungsaktion das Ausgeben eines vom ersten Steuersignal unabhängigen zweiten Steuersignals, das konfiguriert ist, zumindest einen der folgenden Prozesse, insbesondere an der Fahrzeugzustandssignalisierungsvorrichtung oder einer Fahrzeugsteuerung, auszulösen: (i) Überführen der Fahrzeugzustandssignalisierungsvorrichtung in einen sicheren Zustand, insbesondere Deaktivieren der Fahrzeugzustandssignalisierungsvorrichtung oder nur des Signalgebers auf von dem ersten Steuersignal unabhängige Weise; (ii) Ausgeben einer Fehlermeldung an einer Mensch-Maschine-Schnittstelle.

Da das zweite Steuersignal unabhängig vom ersten Steuersignal ist, kann das Überführen der Fahrzeugzustandssignalisierungsvorrichtung in einen sicheren Zustand gemäß der Variante (i) somit auch dann zum Erfolg, d. h. zur gewünschten Deaktivierung führen, wenn der Signalpfad für die Übermittlung des ersten Steuersignals oder dessen Verarbeitung an der Fahrzeugzustandssignalisierungsvorrichtung gestört ist. Dies kann beispielsweise mittels zweier separater Schalter implementiert werden, die voneinander unabhängig jeweils den sicheren Zustand herbeiführen können. Die Variante (ii) korrespondiert zu einem mittelbaren Reagieren auf einen erkannten Fehlerfall mittels Mitteilung desselben an einen Nutzer, sodass dieser sein Verhalten, insbesondere sein Fahrverhalten, dem somit signalisierten Fehlerfall anpassen kann, um somit der Sicherheitsgefährdung zu begegnen. Das Verfahren leistet in diesem Fall zumindest eine Überwachung einschließlich der Mitteilung des Überwachungsergebnisses an einen menschlichen Benutzer und gegebenenfalls in Kombination mit Variante (i) zusätzlich auch eine automatische Überführung der Fahrzeugzustandssignalisierungsvorrichtung in einen sicheren Zustand. Insbesondere Variante (ii) kann im Hinblick auf einen Fehlerfall gelten, bei dem die Signalisierung eine zumindest teilautomatisiere scheinbare gegenwärtige Steuerung des Fahrzeugs signalisiert, beispielsweise mittels einer entsprechenden Anzeige, obwohl tatsächlich nur ein manueller Fahrbetrieb vorherrscht, sodass der Fahrer tatsächlich das Fahrzeug vollständig selbst steuern und kontrollieren muss.

Das zweite Steuersignal kann insbesondere konfiguriert sein, beispielsweise einen entsprechenden (insbesondere digital repräsentierten) Befehl oder ein entsprechendes (insbesondere analoges) Schaltsignal dazu enthalten, die Fahrzeugzustandssignalisierungsvorrichtung zu veranlassen, (i) mittels Selbstdeaktivierung insgesamt oder (ii) mittels selektivem Deaktivieren ihres betroffenen Signalgebers in einen sicheren Zustand überzugehen.

Bei einigen Ausführungsformen wird das Verfahren (i) wiederholt, insbesondere in regelmäßigen Zeitintervallen, und/oder (ii) in Abhängigkeit von dem der Fahrzeugzustandssignalisierungsvorrichtung insgesamt oder einem individuell dem Signalgeber zugeordneten Fahrzeugzustand durchgeführt. Auf diese Weise lässt sich, insbesondere auf Basis von Variante (i), eine regelmäßige bzw. kontinuierliche Überwachung realisieren. Des Weiteren lässt sich, insbesondere auf Basis von Variante (ii), eine in Abhängigkeit vom zugeordneten Fahrzeugzustand selektiv definierte Überwachung realisieren. So kann bezüglich Variante (ii) die Überwachung beispielsweise dann ausgelöst werden, wenn ein manueller Fahrbetriebsmodus (Fahrzeugzustand) aktiviert ist, sodass mittels des Verfahrens gegebenenfalls ein Fehlerfall erkannt werden kann, bei dem entgegen dem tatsächlich vorliegenden Fahrbetriebsmodus eine Signalisierung eines zumindest teilautomatisierten Fahrbetriebs durch die Fahrzeugzustandssignalisierungsvorrichtung bzw. einen bestimmten Signalgeber davon erfolgt.

Bei einigen Ausführungsformen weist die Fahrzeugzustandssignalisierungsvorrichtung eine Mehrzahl von sich untereinander zumindest in einem Signalisierungsaspekt unterscheidenden Signalgebern auf und das Verfahren wird selektiv nur bezüglich einer ersten echten Untermenge der Signalgeber der Fahrzeugzustandssignalisierungsvorrichtung individuell je Signalgeber oder bezüglich einer oder mehrerer vorbestimmter Kombinationen von Signalgebern aus der Untermenge ausgeführt. Bei den Signalgebern kann es sich insbesondere um eine Mehrzahl von optischen Signalgebern handeln, die sich bezüglich ihrer Signalfarbe oder ihrer Signaleffekte (zum Beispiel Blinken, Helligkeit, Helligkeitsverlauf, usw.) unterscheiden. Ein Beispiel dafür ist eine Gruppe aus drei Signalgebern, die jeweils als Leuchtdioden ausgebildet sind, wobei jede der Leuchtdioden eine andere Farbe, beispielsweise rot, grün und blau, aufweist, wobei jeder Leuchtdiode beziehungsweise Signalfarbe ein anderer Fahrzeugzustand zugeordnet ist. So kann etwa in dem oben genannten Beispiel bezüglich verschiedener Fahrbetriebsmodi des Fahrzeugs die rote Leuchtdiode zur Signalisierung eines manuellen Fahrbetriebs (z.B. SAE-Stufe 0, von der "SAE International" Organisation definiert), die blaue Leuchtdiode zur Signalisierung eines teilautomatisierten Fahrbetriebs (z.B. SAE-Stufe 1 oder 2) und die grüne Leuchtdiode zur Signalisierung eines hochautomatisierten Fahrbetriebs (z.B. SAE-Stufen 3 - 5) vorgesehen sein. Die beiden automatisierten Fahrbetriebsstufen können als sicherheitsrelevant eingestuft werden, sodass hier der Fahrer des Fahrzeugs im Regelfall mindestens einige Fahraufgaben an die Automatik abgibt und somit ein Sicherheitsrisiko entstehen kann, wenn die Automatik fehlerhaft arbeitet oder ausfällt. Dementsprechend kann die erste Untermenge der Signalgeber als die aus der blauen und der grünen Leuchtdiode bestehenden Menge definiert sein, sodass die Überwachung nur bezüglich dieser beiden Signalgeber erfolgt, während im manuellen Fahrbetrieb, dem die rote Leuchtdiode zugeordnet ist, deren Überwachung nicht erforderlich ist und somit wegfallen kann, da die Fahraufgabe in diesem Fall sowieso vollständig dem Fahrer obliegt.

Ein zweiter Aspekt betrifft eine Überwachungsvorrichtung, die konfiguriert ist, in Bezug auf eine Fahrzeugzustandssignalisierungsvorrichtung das Verfahren gemäß dem vorgenannten ersten Aspekt der Erfindung auszuführen. Die Überwachungsvorrichtung kann insbesondere als einzelnes Steuergerät (oder Teil desselben) oder als eine zum Zusammenwirken im Rahmen der Ausführung des Verfahrens vorgesehene Gruppe von mehreren über verschiedenen Geräte, insbesondere Steuergeräte, verteilte Überwachungseinheiten implementiert sein.

In einigen Ausführungsformen weist die Überwachungsvorrichtung zumindest eine Prüfvorrichtung auf, die eingerichtet ist, ein an einem Prüfsignalausgang der Fahrzeugzustandssignalisierungsvorrichtung ausgegebenes, insbesondere analoges oder digitales, Prüfsignal zu prüfen, um auf Basis der Prüfung einen aktuellen Betriebszustand des Signalgebers der Fahrzeugzustandssignalisierungsvorrichtung zu bestimmen. So lässt sich die Prüfung im Rahmen des Verfahrens besonders effizient umsetzen. Insbesondere kann auf zusätzliche Sensorik zur Erfassung des Betriebszustands des Signalgebers, wie etwa auf einen lichtempfindlichen Sensor zur Erfassung eines Leuchtzustands eines als Signalgeber eingesetzten Leuchtmittels, verzichtet werden. Bei dem Prüfsignal kann es sich insbesondere um ein Spannungssignal oder um ein Stromsignal handeln, aus dem auf den aktuellen Betriebszustand des Signalgebers geschlossen werden kann. Beispielsweise kann das Prüfsignal einem Spannungsabfall über dem Signalgeber oder einer Stromstärke eines durch ihn fließenden Betriebsstroms, oder einer davon abgeleiteten Größe entsprechen. So weisen beispielsweise Leuchtdioden als Signalgeber typischerweise eine charakteristische Vorwärtsspannung während ihres Betriebs auf, sodass die Messung eines zu dieser charakteristischen Vorwärtsspannung korrespondierenden Prüfsignals auf einen aktivierten Zustand, d. h. auf ein Leuchten, der Leuchtdiode geschlossen werden kann.

Ein dritter Aspekt betrifft ein Computerprogram, das konfiguriert ist, bei seiner Ausführung auf einer Überwachungsvorrichtung nach dem zweiten Aspekt das Verfahren gemäß dem ersten Aspekt der Erfindung auszuführen.

Das Computerprogramm kann insbesondere auf einem nichtflüchtigen Datenträger gespeichert sein. Bevorzugt ist dies ein Datenträger in Form eines optischen Datenträgers oder eines Flashspeichermoduls. Dies kann vorteilhaft sein, wenn das Computerprogramm als solches unabhängig von einer Prozessorplattform gehandelt werden soll, auf der das ein bzw. die mehreren Programme auszuführen sind. In einer anderen Implementierung kann das Computerprogramm als eine Datei auf einer Datenverarbeitungseinheit, insbesondere auf einem Server vorliegen, und über eine Datenverbindung, beispielsweise das Internet oder eine dedizierte Datenverbindung, wie etwa ein proprietäres oder lokales Netzwerk, herunterladbar sein. Zudem kann das Computerprogramm eine Mehrzahl von zusammenwirkenden einzelnen Programmodulen aufweisen.

Die Überwachungsvorrichtung kann entsprechend einen Programmspeicher aufweisen, in dem das Computerprogramm abgelegt ist. Alternativ kann die Überwachungsvorrichtung auch eingerichtet sein, über eine Kommunikationsverbindung auf ein extern, beispielsweise auf einem oder mehreren Servern oder anderen Datenverarbeitungseinheiten verfügbares Computerprogramm zuzugreifen, insbesondere um mit diesem Daten auszutauschen, die während des Ablaufs des Verfahrens bzw. Computerprogramms Verwendung finden oder Ausgaben des Computerprogramms darstellen.

Die in Bezug auf den ersten Aspekt der Erfindung erläuterten Merkmale und Vorteile gelten entsprechend auch für den zweiten und dritten Aspekts der Erfindung.

Die Erfindung betrifft eine Fahrzeugzustandssignalisierungsvorrichtung, insbesondere eine Vorrichtung zur Signalisierung eines aktivierten zumindest teilautomatisierten Fahrbetriebszustand eines Kraftfahrzeugs. Die Fahrzeugzustandssignalisierungsvorrichtung weist auf: (i) einen Signalgeber der konfiguriert ist, ein Zustandssignal zur Signalisierung eines dem Signalgeber zugeordneten Fahrzeugzustands auszugeben; und (ii) eine Schaltung zur Ansteuerung des Signalgebers, um diesen in Reaktion auf zumindest ein entsprechendes Steuersignal, insbesondere eines entsprechenden von einer Überwachungsvorrichtung nach dem zweiten Aspekt der Erfindung übermittelten Steuersignals, selektiv zu aktivieren oder zu deaktivieren. Die Schaltung weist einen ersten Schalter und einen davon unabhängig schaltbaren zweiten Schalter sowie zumindest einen Prüfsignalausgang zur Bereitstellung eines Prüfsignals zum Prüfen eines aktuellen Betriebszustands des Signalgebers auf. Zudem ist die Schaltung so konfiguriert, dass zur Aktivierung des Signalgebers der erste und der zweite Schalter zusammen eine spezielle vorbestimmte Schaltzustandskombination aufweisen müssen, während Schaltzustandskombinationen der Schalter, die der speziellen Schaltzustandskombination des ersten und des zweiten Schalters nicht entsprechen oder diese beinhalten, zu einer Deaktivierung des Signalgebers korrespondieren.

Diese schalterbasierte Lösung hat den Vorteil, dass nur die spezielle Schaltzustandskombination zur Aktivierung des Signalgebers führt, während es eine Mehrzahl weiterer Schaltzustände gibt (mindestens einer der Schalter befindet sich in einer anderen Stellung, als diejenige, die er für die spezielle Schaltzustand Kombination einnimmt), die zu einem nicht aktivierten Zustand des Signalgebers korrespondieren. Wenn beispielsweise der aktivierte Zustand des Signalgebers zu einer geschlossenen Schalterstellung beider Schalter korrespondiert, dann kann mittels jeden einzelnen der Schalter eine Deaktivierung des Signalgebers erreicht werden. Zudem kann jeder einzelne der beiden Schalter im Hinblick auf sein fehlerfreies Funktionieren, insbesondere Abschalten, getestet werden, in dem er geöffnet und der jeweils andere Schalter geschlossen wird. Ergibt sich sodann während der Prüfung, dass der Signalgeber trotz des einen geöffneten Schalters aktiviert ist, so lässt sich daraus auf eine Fehlfunktion des eigentlich "geöffneten" Schalters schließen, da dieser gemäß Prüfergebnis tatsächlich strom- bzw. signalleitend wirkt, beispielsweise aufgrund eines Kurzschlusses. Auch andere spezielle Schalterkombinationen sind möglich, wie unter im Zusammenhang mit den nachfolgend aufgeführten weiteren Ausführungsformen beschrieben.

Bei einigen solcher schalterbasierten Ausführungsformen ("Variante 1") weist die Schaltung einen Spannungsteiler mit zwei in Reihe geschalteten Zweipolen auf und der Prüfsignalausgang geht von einem zwischen den beiden Zweipolen gelegenen Schaltungspunkt aus. In einem ersten der Zweipole sind der erste und der zweite Schalter angeordnet, insbesondere in Reihe geschaltet, und in dem zweiten der Zweipole ist der Signalgeber angeordnet, wobei der Signalgeber nur dann mittels einer über dem Spannungsteiler angelegten Betriebsspannung aktiviert werden kann, wenn sich der erste und der zweite Schalter zugleich jeweils im geschlossenen Schaltzustand befinden.

Auf diese Weise ist es möglich, andere Schalterstellungen, bei denen nicht beide Schalter gleichzeitig geschlossen sind, zum Prüfen der Schaltung zu verwenden. Dies gilt insbesondere für Schalterstellungen, bei denen einer der Schalter geschlossen und der jeweils andere Schalter geöffnet ist. Ist in einem solchen Fall der Signalgeber dennoch aktiv, kann auf einem Fehler im Zusammenhang mit dem eigentlich gemäß seiner Ansteuerung "geöffneten" Schalter geschlossen werden. Ein solcher Fehler kann insbesondere in Form eines Kurzschlusses oder einer fehlerhaften Ansteuerung des Schalters vorliegen. Auf ähnliche Weise kann auf einen Fehler bezüglich beider Schalter geschlossen werden, wenn, obwohl beide Schalter gemäß ihrer Ansteuerung "geöffnet" sind, der Signalgeber dennoch aktiv ist.

Ob sich der Signalgeber gegenwärtig in einem aktivierten Betriebszustand befindet oder nicht, kann mittels einer elektrischen Messung, insbesondere eines am Prüfsignalausgang vorliegenden Spannungspotentials oder eines Stromflusses durch den Schaltungspunkt, von dem der Prüfsignalausgang ausgeht, erfasst werden. Zumindest eine der Schalterstellungen, bei denen zumindest einer der Schalter geöffnet ist, kann somit als Diagnosestellung genutzt werden. Sie kann sich insbesondere von einer anderen dieser Schalterstellungen, die zum regulären Ausschalten des Signalgebers verwendet wird, unterscheiden. Beispielsweise könnte die reguläre "Aus"-Stellung zu einem geöffneten Zustand beider Schalter korrespondieren, während die beiden Stellungen, bei denen jeweils ein Schalter geschlossen und andere geöffnet sind, jeweils als eine Diagnosestellung im Rahmen der Prüfung des tatsächlichen Betriebszustands des Signalgebers verwendet werden können. Ein sicherer Zustand kann dann insbesondere der regulären "Aus"-Stellung entsprechen.

Bei einigen anderen solcher schalterbasierten Ausführungsformen ("Variante 2") weist die Schaltung wieder einen Spannungsteiler mit zwei in Reihe geschalteten Zweipolen auf und der Prüfsignalausgang geht von einem zwischen den beiden Zweipolen gelegenen Schaltungspunkt aus. Jedoch sind bei dieser Variante in einem ersten der Zweipole der erste Schalter und in dem zweiten der Zweipole der Signalgeber und der zweite Schalter angeordnet. Der Signalgeber kann dabei nur dann mittels einer über dem Spannungsteiler angelegten Betriebsspannung aktiviert werden, wenn sich der erste und der zweite Schalter zugleich jeweils im geschlossenen Schaltzustand befinden. Ansonsten gilt das zu Variante 1 Gesagte entsprechend auch für Variante 2.

Bei einigen Ausführungsformen ("Variante 3"), die jeweils einen Spezialfall von Variante 2 darstellen, ist in dem zweiten Zweipol der zweite Schalter parallel zu dem Signalgeber geschaltet und der Signalgeber kann nur dann mittels einer über dem Spannungsteiler angelegten Betriebsspannung aktiviert werden, wenn sich der erste Schalter im geschlossenen Schaltzustand befindet und sich zugleich der zweite Schalter im geöffneten Schaltzustand befindet. Somit sind zur regulären Aktivierung des Signalgebers der erste Schalter zu schließen und der zweite Schalter zu öffnen.

Zum regulären Deaktivieren des Signalgebers kann insbesondere der zweite Schalter geschlossen werden, wahlweise zusätzlich auch der erste Schalter. Eine Diagnosestellung kann dann insbesondere darin bestehen, dass beide Schalter geöffnet sind. Liegt dann am ersten Schalter ein Fehler vor (beispielsweise Kurzschluss) der zu einer Stromversorgung des Signalgebers führt, kann über die Aktivität des Signalgebers auf einen Fehler am ersten Schalter geschlossen werden. Wenn andererseits beide Schalter geschlossen sind und der Signalgeber dennoch tatsächlich aktiv ist, kann auf eine Fehlfunktion des zweiten Schalters geschlossen werden (d. h. er leitet Strom, obwohl er gemäß seiner Ansteuerung eigentlich geöffnet sein sollte). Diese Variante hat den zusätzlichen Vorteil, dass wenn der zweite Schalter geschlossen ist, und somit den Signalgeber überbrückt, ein parasitärer Spannungsaufbau am Signalgeber, insbesondere wenn dieser eine oder mehrere Leuchtdioden enthält, vermieden werden kann.

Bei einigen Ausführungsformen, die insbesondere in Kombination mit jeder der Varianten 1 bis 3 zur Anwendung kommen können, ist der Spannungsteiler ein belasteter Spannungsteiler, bei dem der zweite Zweipol eine parallel zu dem Signalgeber geschalteten Last aufweist. Die Last kann insbesondere mittels eines sogenannten (z.B. ohmschen) Pull-Down-Widerstands ausgebildet sein. Dies hat den Vorteil, dass mittels der Wahl der Last ein Arbeitspunkt für den Prüfsignalausgang eingestellt werden kann. Insbesondere kann so dafür gesorgt werden, dass wenn aufgrund einer entsprechenden Schalterstellung des ersten Schalters im ersten Zweipol der Prüfsignalausgang nicht durch die am Spannungsteiler angelegten Betriebsspannung versorgt ist, der Prüfsignalausgang auf ein niedrigeres Potenzial, insbesondere Massepotenzial gezogen wird, um anstelle eines schwebenden Zustands ein definiertes Potenzial bzw. Prüfsignal am Prüfsignalausgang zu erhalten, das eine sichere Unterscheidung von anderen Schaltzuständen bei der Messung am Prüfsignalausgang erlaubt.

Die Erfindung betrifft weiter ein System zur überwachten Fahrzeugzustandssignalisierung, insbesondere einer Signalisierung eines aktivierten zumindest teilautomatisierten Fahrbetriebszustands eines Kraftfahrzeugs. Das System weist eine Überwachungsvorrichtung nach dem zweiten Aspekt sowie eine damit signalverbundene Fahrzeugzustandssignalisierungsvorrichtung nach dem vierten Aspekt der Erfindung auf.

Bei einigen Ausführungsformen ist das System auf zwei oder mehr verschiedene Geräte, insbesondere Steuergeräte für ein Fahrzeug, aufgeteilt. Der erste Schalter und der zweite Schalter der Fahrzeugzustandssignalisierungsvorrichtung sind in zwei verschiedenen der Geräte angeordnet. Zudem ist der Prüfsignalausgang der Fahrzeugzustandssignalisierungsvorrichtung zu zumindest zweien der Geräte geführt und diese zumindest zwei Geräte sind jeweils eingerichtet, das Verfahren gemäß dem ersten Aspekt der Erfindung einzeln oder kumulativ miteinander in Bezug auf die Fahrzeugzustandssignalisierungsvorrichtung des Systems auszuführen. Auf diese Weise kann die Sicherheit weiter erhöht werden, da die Funktionalität des Systems, insbesondere im Hinblick auf die Prüfung des tatsächlichen aktuellen Betriebszustand des zumindest einen Signalgebers, auf verschiedene Geräte verteilt ist. Somit ist eine Diagnose auch dann möglich, wenn ein Fehlerfall an einem der Geräte auftritt, der dieses Gerät selbst auch außerstande setzt, die Diagnose bzw. Prüfung des Betriebszustandes des Signalgebers vorzunehmen. Auch die Herstellung eines sicheren Zustands kann somit dann von zumindest einem der anderen Geräte aus erfolgen. Bei einigen Ausführungsformen weist die Fahrzeugzustandssignalisierungsvorrichtung eine Mehrzahl von sich untereinander zumindest in einem Signalisierungsaspekt unterscheidenden Signalgebern auf. Die Überwachungsvorrichtung ist eingerichtet, bezüglich der Fahrzeugzustandssignalisierungsvorrichtung das Verfahren nach dem ersten Aspekt der Erfindung selektiv für jeden der Signalgeber individuell auszuführen. Somit kann die Prüfung bezüglich jedes der Signalgeber individuell und unabhängig von den Prüfungen bezüglich der anderen Signalgeber erfolgen, was insbesondere eine genauere Eingrenzung oder Identifikation von etwaigen Fehlern erlaubt. Insbesondere kann ein solches System zudem konfiguriert sein, in dem Fall, dass die Prüfung bezüglich eines der Signalgeber ergibt, dass sich dieser Signalgeber trotz des entsprechenden übermittelten Steuersignals in einem aktivierten Betriebszustand befindet, selektiv diesen Signalgeber zu deaktivieren. So lässt sich selektiv ein auf diesen signalgeberbezogener sicherer Zustand herstellen, ohne dass die Funktionalität der anderen Signalgeber beeinträchtigt wird.

Die Erfindung betrifft schließlich ein Fahrzeug, insbesondere ein Kraftfahrzeug, das ein System gemäß der Erfindung aufweist.

Weitere Vorteile, Merkmale und Anwendungsmöglichkeiten der vorliegenden Erfindung ergeben sich aus der nachfolgenden detaillierten Beschreibung im Zusammenhang mit den Figuren.

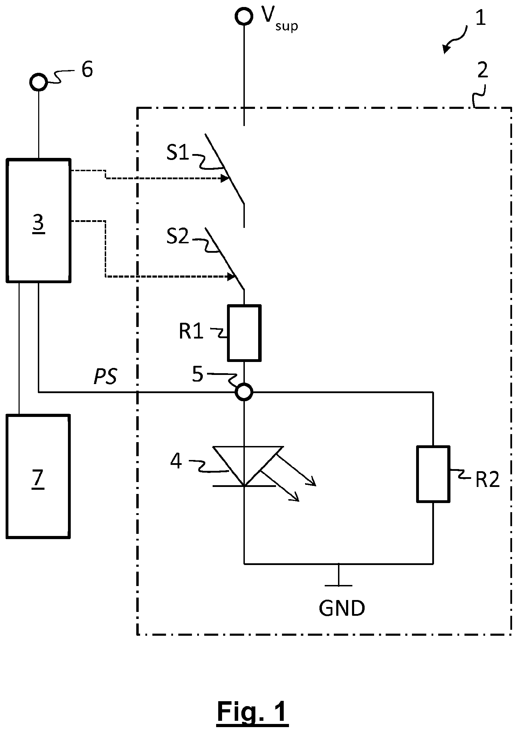

Dabei zeigen die **Figuren 1 bis 7** jeweils schematisch eine ausgewählte beispielhafte Ausführungsform eines erfindungsgemäßen Systems, wobei sich diese einzelnen Ausführungsformen voneinander unterscheiden. In den Figuren werden durchgängig dieselben Bezugszeichen für dieselben oder einander entsprechenden Elemente der Erfindung verwendet.

**Fig. 1** stellt eine erste Ausführungsform eines erfindungsgemäßen Systems 1 dar, welches eine Fahrzeugzustandssignalisierungsvorrichtung 2 sowie eine Überwachungsvorrichtung 3 aufweist. Die Fahrzeugzustandssignalisierungsvorrichtung 2 enthält einen belasteten Spannungsteiler aus zwei Zweipolen. Ein erster der Zweipole enthält eine Reihenschaltung aus zwei Schaltern S1 und S2, sowie einem ohmschen Lastwiderstand R1. Der zweite der Zweipole enthält einen Signalgeber 4, beispielsweise - wie dargestellt - eine Leuchtdiode, zu der ein Pull-Down-Widerstand R2 parallelgeschaltet ist und somit den Spannungsteiler zum belasteten Spannungsteiler macht.

Der Spannungsteiler verfügt über einen Betriebsspannungsanschluss V_{SUP} und einen zugehörigen Masseanschluss GND, sodass bei seinem Betrieb eine Betriebsspannung über dem Spannungsteiler angelegt werden kann. Von einem Verbindungspunkt (Schaltungspunkt) zwischen den beiden Zweipolen geht ein Prüfsignalausgang 5 für ein Prüfsignal PS aus, der mit der Überwachungsvorrichtung 3 signalverbunden ist. Die beiden Schalter S1 und S2 sind über entsprechende Schaltsignale von der Überwachungsvorrichtung 3 individuell steuerbar. Die Überwachungsvorrichtung 3 kann insbesondere über einen oder mehrere Prozessoren sowie einen Speicher verfügen (jeweils nicht dargestellt), in dem ein Computerprogramm abgelegt ist, mittels dem das erfindungsgemäße Verfahren implementiert ist.

Wenn ein dem Signalgeber zugeordneter Fahrzeugzustand vorliegt, der durch den Signalgeber 4 signalisiert werden soll, so wird die Fahrzeugzustandssignalisierungsvorrichtung 2 in einen aktiven Betriebszustand versetzt, indem von Überwachungsvorrichtung 3 die beiden Schalter S1 und S2 so angesteuert werden, dass sie geschlossen werden. Somit wird der Spannungsteiler leitend und es fließt ein insbesondere mittels der beiden Widerstände R1 und R2, sowie dem Widerstand des Signalgebers 4 definierter Strom, mittels dessen der Signalgeber aktiviert wird, im Beispielfall die Leuchtdiode also zum Leuchten gebracht wird. Liegt dagegen der dem Signalgeber 4 zugeordnete Fahrzeugzustand nicht vor, so wird die Fahrzeugzustandssignalisierungsvorrichtung 2 in einen deaktivierten Betriebszustand versetzt, indem die beiden Schalter S1 und S2 durch die Überwachungsvorrichtung 3 so angesteuert werden, dass sie beide geöffnet werden, wodurch der Stromfluss unterbrochen ist, und der Signalgeber 4 im fehlerfreien Fall deaktiviert wird. Die Erfassung des dem Signalgeber zugeordneten Fahrzeugzustands kann insbesondere mittels einer zur Überwachungsvorrichtung 3 selbst gehörenden entsprechenden Sensorik (nicht dargestellt) erfolgen. Zusätzlich oder alternativ kann die Überwachungsvorrichtung 3, wie dargestellt, über einen Fahrzeugzustandssignaleingang 6 verfügen, über den sie eine den Fahrzeugzustand charakterisierendes Zustandssignal, beispielsweise von einer Fahrzeugsteuerung oder einer systemexternen Sensorik empfangen kann.

In vordefinierten, regelmäßigen Zeitabständen, insbesondere wenn sich die Fahrzeugzustandssignalisierungsvorrichtung 2 in ihrem deaktivierten Betriebszustand befindet, wird verfahrensgemäß die Fahrzeugzustandssignalisierungsvorrichtung 2 in einen Diagnosezustand versetzt, indem die beiden Schalter S1 und S2 durch die Überwachungsvorrichtung 3 mittels zumindest eines ersten Steuersignals so angesteuert werden, dass einer der beiden Schalter geöffnet und der andere geschlossen wird. Im fehlerfreien Fall sollte somit der Signalgeber 4 deaktiviert sein, da der geöffnete Schalter den Stromfluss unterbricht. Um zu prüfen, ob tatsächlich der Signalgeber 4 dennoch fehlerhaft aktiviert ist, wird am Prüfsignalausgang 5 das Spannungspotenzial am Prüfsignalausgang 5 abgegriffen und durch die Überwachungsvorrichtung 3 ausgewertet. Das Spannungspotenzial entspricht hier dem Spannungsabfall über dem Signalgeber 4.

Falls der Signalgeber 4, hier die Leuchtdiode, fehlerhaft aktiviert ist, was insbesondere dadurch hervorgerufen sein kann, dass der gemäß seiner Ansteuerung eigentlich geöffnete Schalter fehlerhaft weiterhin geschlossen ist, oder einen Kurzschluss aufweist, fällt über dem Signalgeber 4 eine für seinen Betrieb typische, bekannte Vorwärtsspannung ab. Bei der Auswertung in der Überwachungsvorrichtung 3 kann diese als solche erkannt werden, daraus auf den aktivierten Zustand des Signalgebers 4 geschlossen werden und mittels zumindest einem zweiten Steuersignal eine entsprechende Fehlerbegegnungsaktion ausgelöst werden. Letztere kann insbesondere darin bestehen, dass die Fahrzeugzustandssignalisierungsvorrichtung 2 durch die Überwachungsvorrichtung 3 mittels dem zumindest einen zweiten Steuersignal so angesteuert wird, dass dadurch auch der zunächst noch geschlossene der beiden Schalter geöffnet wird und somit die Fahrzeugzustandssignalisierungsvorrichtung 2 in den sicheren vollständig deaktivierten Betriebszustand versetzt wird. Zusätzlich oder alternativ dazu kann im Fehlerfall an einer mit der Überwachungseinheit 2 signalverbundenen Mensch-Maschine-Schnittstelle 7 ein Warnsignal ausgegeben werden. Andernfalls, d.h. im tatsächlich fehlerfreien Fall, wird das Potenzial am Punkt 5 dagegen durch den Pull-Down-Widerstand auf Massepotenzial GND gezogen, wodurch eine leichte Unterscheidung zum Fehlerfall ermöglicht wird.

Alternativ zu der Spannungsmessung, kann am Schaltungspunkt 5 insbesondere auch eine Strommessung erfolgen, um aus dem gemessenen Strom auf den tatsächlichen Betriebszustand des Signalgebers 4 schließen zu können. Dieser Diagnosevorgang kann entweder nur für einen der beiden Schalter S1 und S2, oder aber nacheinander für beide Schalter erfolgen.

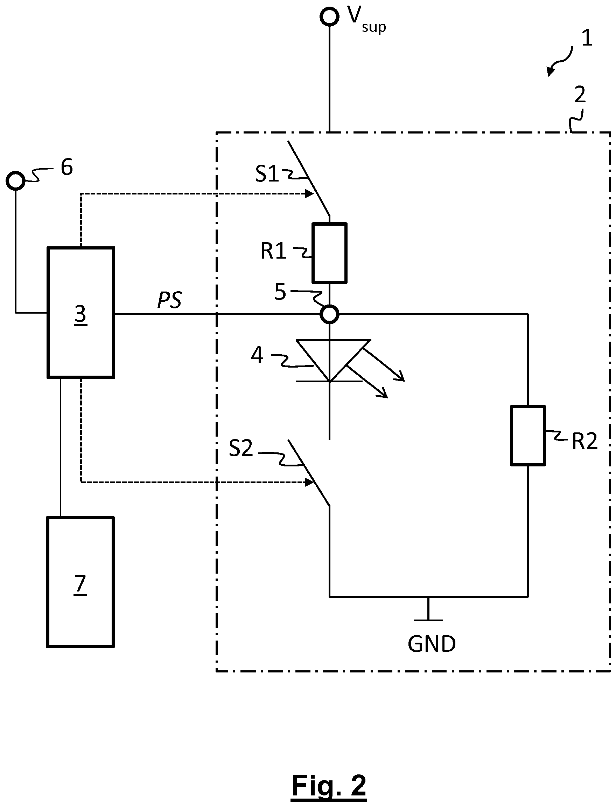

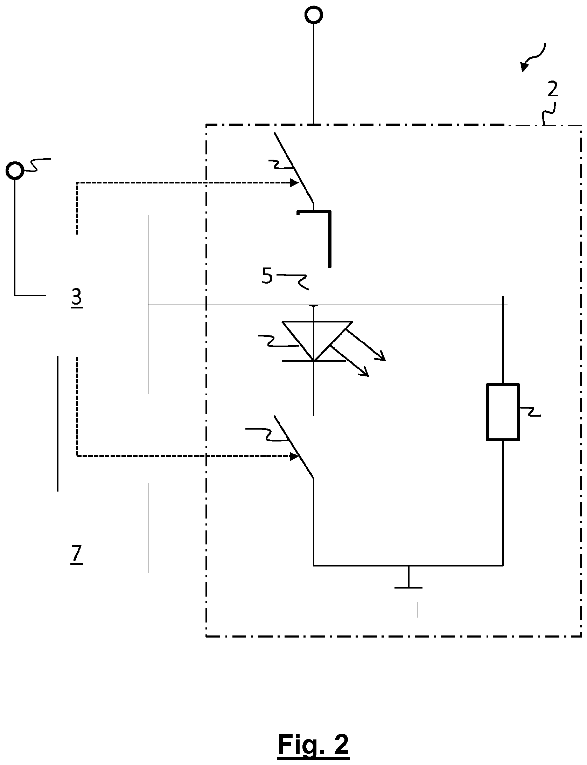

**Fig. 2** zeigt eine zweite, alternative Ausführung des Systems 1, die sich von der in Figur 1 dargestellten Ausführungsform dadurch unterscheidet, dass der zweite Schalter S2 statt im ersten Zweipol nun im zweiten Zweipol und in Reihe zu dem Signalgeber 4 geschaltet ist. Auch bei dieser Schaltung gilt, dass im fehlerfreien Fall der Signalgeber 4 nur dann aktiviert ist, wenn beide Schalter S1 und S2 geschlossen sind. Der Betrieb der Schaltung entspricht dem oben unter Bezug auf Fig. 1 beschriebenen.

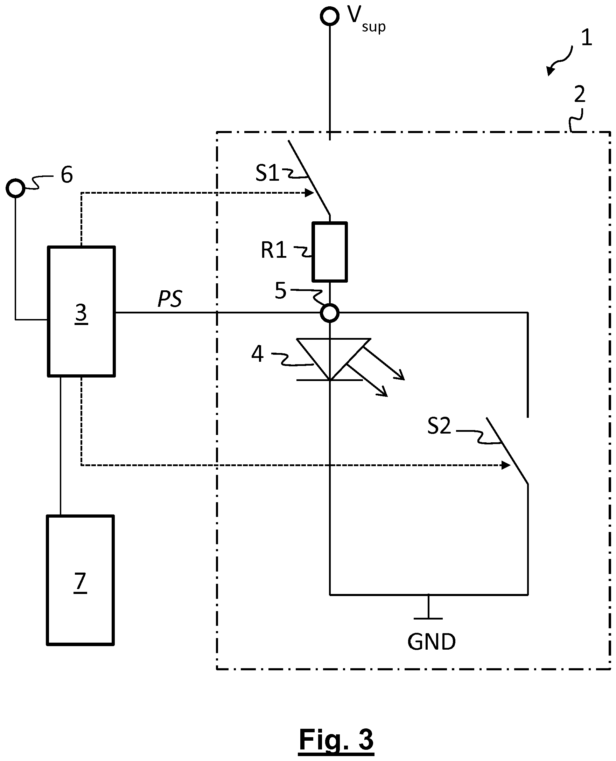

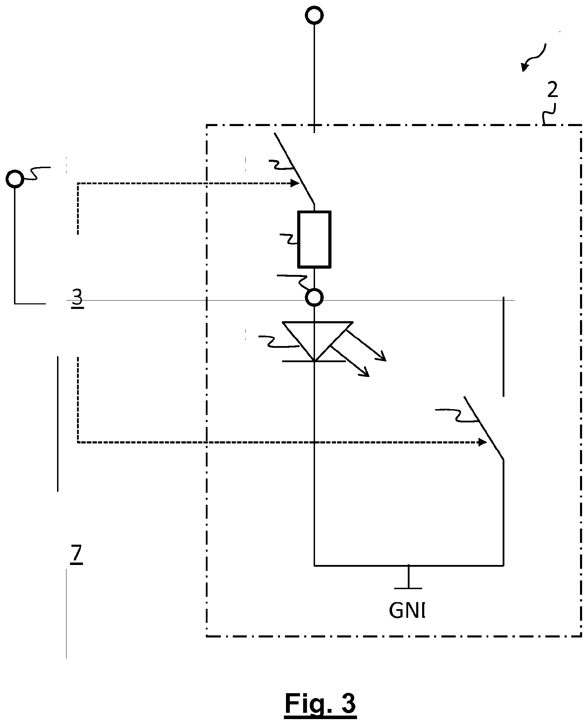

**Fig. 3** zeigt eine dritte, alternative Ausführung des Systems 1, die sich von der in Figur 2 dargestellten Ausführungsform dadurch unterscheidet, dass der zweite Schalter S2 im zweiten Zweipol statt in Reihe zu dem Signalgeber 4 nun anstelle des Widerstands R2 (oder zusätzlich dazu) parallel zum Signalgeber 4 geschaltet ist. Bei dieser Schaltung gilt, dass im fehlerfreien Fall der Signalgeber 4 nur dann aktiviert ist, wenn der Schalter S1 geschlossen und der Schalter S2 geöffnet ist. Der Betrieb der Schaltung entspricht ansonsten dem oben unter Bezug auf Fig. 1 beschriebenen.

Die Fahrzeugzustandssignalisierungsvorrichtung 2 kann dementsprechend verfahrensgemäß in einen Diagnosezustand versetzt werden, wenn sie durch die Überwachungsvorrichtung 3 so angesteuert wird, dass im fehlerfreien Fall beide Schalter S1 und S2 geöffnet werden. Ergibt die Messung am Prüfsignalausgang 5 bei einer solchen Schalterstellung, dass die Signalgeber 4 dennoch im aktiven Zustand ist, so lässt dies auf eine Fehlfunktion des Schalters S1 oder seiner Ansteuerung schließen, beispielsweise auf einen Kurzschluss. Ein anderer Diagnosezustand der Fahrzeugzustandssignalisierungsvorrichtung 2 kann darin bestehen, dass die Überwachungsvorrichtung 3 die Fahrzeugzustandssignalisierungsvorrichtung 2 so ansteuert, dass im fehlerfreien Fall beide Schalter geschlossen werden. Ergibt dann die Messung am Prüfsignalausgang 5, dass der Signalgeber 4 dennoch aktiviert ist, so lässt dies auf eine Fehlfunktion des Schalters S2 oder seiner Ansteuerung schließen, etwa auf einen Leitungsbruch oder eine andere Art von Unterbrechung. Diese Ausführungsform hat zusätzlich den Vorteil, dass wenn der Schalter S2 geschlossen ist, etwaige am Signalgeber 4 entstehende, unerwünschte Spannungen über den Schalter S2 abgebaut werden. Dies kann insbesondere dann der Fall sein, wenn es sich bei dem Signalgeber 4 um eine Leuchtdiode oder ein anderes Halbleiterbauelement handelt, bei dem unter Umständen, insbesondere mittels externer Einstrahlung elektromagnetischer Wellen, intrinsisch parasitäre Spannungen erzeugt werden können.

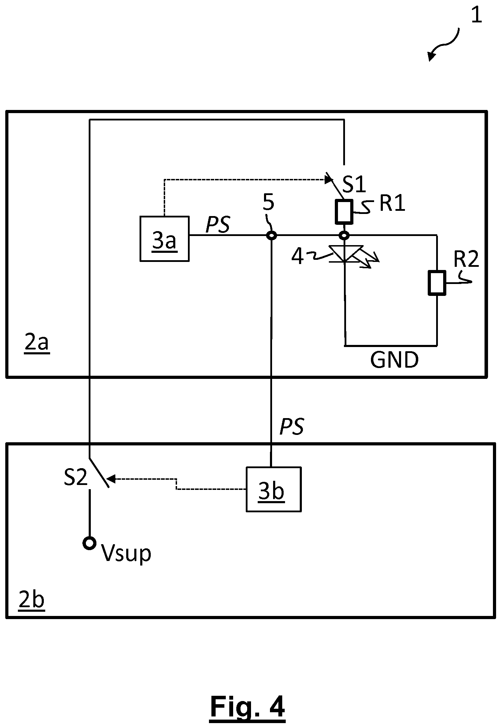

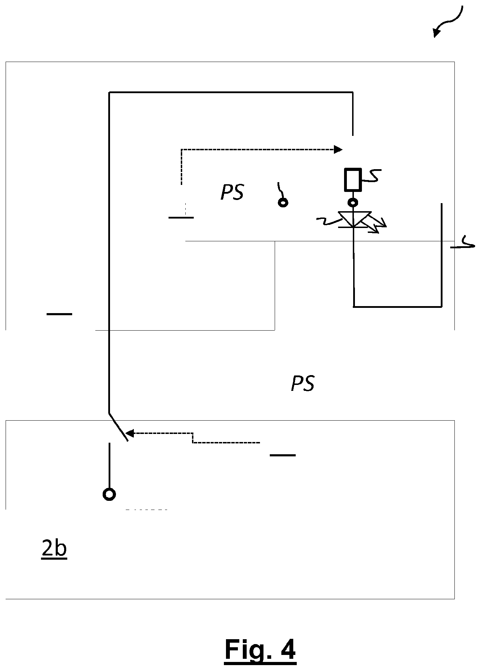

**Fig. 4** zeigt eine vierte, alternative Ausführung des Systems 1, die weitgehend derjenigen aus Fig. 1 entspricht, jedoch mit der Besonderheit, dass das System 1 auf zwei verschiedene Steuergeräte 2a und 2b verteilt aufgebaut ist. Dabei stellt das Steuergerät 2a zugleich die Fahrzeugzustandssignalisierungsvorrichtung 2 des Systems 1 dar, während die Überwachungsvorrichtung 3 in zwei Überwachungseinheiten 3a bzw. 3b unterteilt ist, wobei die Überwachungseinheit 3a einen Teil des Steuergeräts 2a bildet und die Überwachungseinheit 3b einen Teil des Steuergeräts 2b bildet. Beide Überwachungseinheiten 3a, 3b sind jeweils mit dem Prüfsignalausgang 5 der Fahrzeugzustandssignalisierungsvorrichtung 2 verbunden, um dort ein Prüfsignal PS abzugreifen. Jede der Überwachungseinheiten 3a, 3b ist eingerichtet den ihr zugeordneten der beiden Schalter S1 und S2 anzusteuern, wobei jedes der beiden Steuergeräte 2a, 2b einen der beiden in Reihe geschalteten Schalter S1 und S2 aufweist. Der modulare Aufbau aus zwei Steuergeräten 2a, 2b hat insbesondere den Vorteil, dass im Falle eines Defekts normalerweise nur eines der beiden Steuergeräte 2a, 2b ausgetauscht werden muss. Außerdem ist anhand der beiden Überwachungseinheiten 3a, 3b die Prüfung mittels des Prüfsignals PS redundant aufgebaut, sodass eine Fehlfunktion selbst dann erkannt werden kann, wenn eine der beiden Überwachungseinheiten 3a, 3b selbst oder ihre Signalanbindung an den Prüfsignalausgang 5 defekt ist.

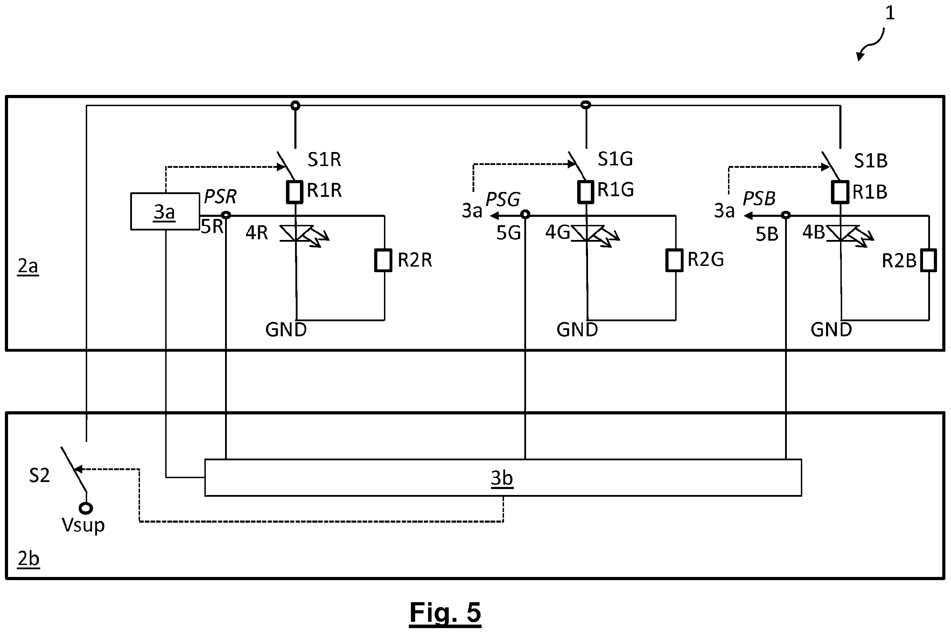

**Fig. 5** zeigt eine fünfte, alternative Ausführung des Systems 1, die von derjenigen aus Fig. 4 abgeleitet ist, jedoch mit der Besonderheit, dass eine Mehrzahl von Signalgebern 4R, 4G, 4B jeweils mit einer entsprechenden Beschaltung gemäß Fig. 4 vorgesehen ist. Allerdings ist der Schalter S2 nicht jeweils separat für jeden der Signalgeber 4R, 4G, 4B ausgeführt, sondern durch einen allen Signalgebern 4R, 4G, 4B gemeinsam vorgeschalteten einzigen Schalter implementiert. Mittels des jeweiligen individuell vorgesehenen anderen Schalters S1R, S1G bzw. S1B, kann jedoch jeder Signalgeber individuell aktiviert bzw. deaktiviert werden, wenn der Schalter S2 geschlossen ist. Analog zu Fig. 4 sind für die individuelle Beschaltung der Signalgeber 4R, 4G, 4B jeweils entsprechenden Widerstände R1R, R1G bzw. R1B sowie R2R, R2G bzw. R2B vorgesehen.

Zu jedem der Signalgeber 4R, 4G, 4B existiert ein entsprechender individueller Prüfsignalausgang 5R, 5G bzw. 5B, an dem ein entsprechendes Prüfsignal PSR, PSG bzw. PSB durch die Überwachungseinheit 3a abgegriffen werden kann. Bei den verschiedenen Signalgebern 4R, 4G, 4B kann es sich insbesondere um in derselben Fahrzeugzustandssignalisierungsvorrichtung 2 zusammengefassten Leuchtmittel, beispielsweise Leuchtdioden, verschiedener Farben handeln, wodurch sich eine Anzeige ausbilden lässt, deren Signalisierung je nach zugehörigem zu signalisierenden Fahrzeugzustand verschiedene Farben oder Farbkombinationen umfasst. Beispielsweise, könnte eine grüne Leuchtdiode 4G zu einem hochautomatisierten Fahrzustand (d.h. Fahrbetrieb) eines mit dem System 1 ausgerüsteten Fahrzeugs, eine blaue Leuchtdiode 4B zu einem teilautomatisierten Fahrzustand, und eine rote Leuchtdiode 4R zu einem manuellen Fahrzustand korrespondieren.

Die Prüfsignale PSR, PSG bzw. PSB können durch die Überwachungseinheiten 3a bzw. 3b jeweils als analoge Signale empfangen verarbeitet werden. Alternativ ist es auch denkbar, die Prüfsignale PSR, PSG bzw. PSB als digitale Signale zu erzeugen oder in solche umzuwandeln und in den Überwachungseinheiten 3a bzw. 3b digital zu verarbeiten. Letzteres kann insbesondere mittels eines Diagnoseprotokolls erfolgen, beispielsweise, wenn es sich bei den Signalgebern um sogenannte "Smart LEDs" handelt. Bei der Signalverarbeitung kann für jeden der Signalgeber individuell die Prüfung und gegebenenfalls das Auslösen einer Federbegegnungsmaßnahme, wie etwa das Öffnen des zugehörigen Schalters S1R, S1G zu S1B zur Herstellung eines jeweiligen sicheren Zustands erfolgen.

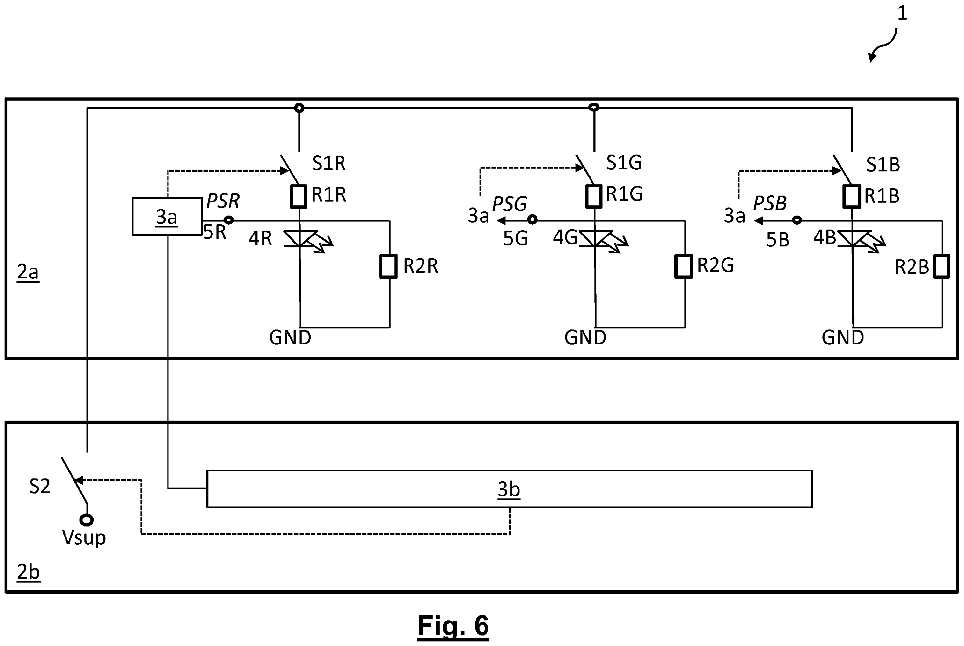

**Fig. 6** zeigt eine sechste, alternative Ausführung des Systems 1, die von derjenigen aus Fig. 5 abgeleitet ist, jedoch mit der Besonderheit, dass hier sämtliche Prüfsignalausgänge 5R, 5G und 5B zur Überwachungseinheit 3a geführt sind und dort digitalisiert werden, und erst von dort als, optional per Multiplex zusammengefasste, Prüfsignale an die zweite Überwachungseinheit 3b im Steuergeräts 2b übermittelt werden. Die Verarbeitung der erfassten Prüfsignale PSR, PSG und PSB im Diagnosemodus erfolgt dementsprechend digital.

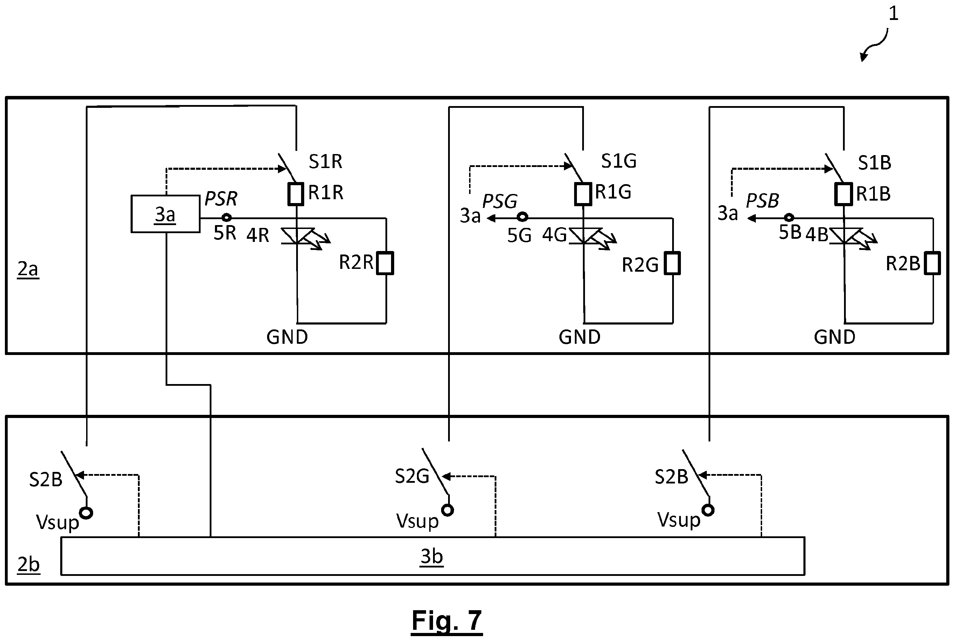

**Fig. 7** zeigt schließlich eine siebte, alternative Ausführung des Systems 1, die von derjenigen aus Fig. 6 abgeleitet ist, jedoch mit der Besonderheit, dass nun auch der zweite Schalter S2 nicht mehr als gemeinsamer Schalter, sondern jeweils individuell anhand der Schalter S2R, S2G bzw. S2B ausgeführt ist. Dies hat den Vorteil, dass im Fehlerfall jeder der Signalgeber 4R, 4G bzw. 4B individuell mittels Abschalten durch den entsprechenden Schalter S2R, S2G bzw. S2B in einen sicheren Zustand überführt werden kann.

### Bezugszeichenliste

- 1: System zur überwachten Fahrzeugzustandssignalisierung
- 2: Fahrzeugzustandssignalisierungsvorrichtung
- 2a, b: Steuergeräte
- 3: Überwachungsvorrichtung
- 3a, b: Überwachungseinheiten
- 4, 4R, 4G, 4B: jeweils Signalgeber
- 5, 5R, 5G, 5B: jeweils Prüfsignalausgang, bzw. Verbindungspunkt beider Zweipole
- 6: Fahrzeugzustandssignaleingang
- 7: Mensch-Maschine-Schnittstelle
- S1, S1R, S1G, S1B: jeweils erster Schalter
- S2, S2R, S2G, S2B: jeweils zweiter Schalter
- R1,R1R, R1G, R1B: jeweils Widerstand, insbesondere zur Begrenzung des Stroms durch den zugeordneten Signalgeber
- R2,R2R, R2G, R2B: jeweils Pull-down-Widerstand
- Vsup: Betriebsspannungsanschluss
- GND: Masseanschluss
- PS,PSR, PSG, PSB: Prüfsignale

## Patentansprüche

1. Fahrzeugzustandssignalisierungsvorrichtung (2), insbesondere Vorrichtung zur Signalisierung eines aktivierten zumindest teilautomatisierten Fahrbetriebszustands eines Kraftfahrzeugs, aufweisend:
Einen Signalgeber (4) der konfiguriert ist, ein Zustandssignal zur Signalisierung eines dem Signalgeber (4) zugeordneten Fahrzeugzustands auszugeben; und
eine Schaltung zur Ansteuerung des Signalgebers (4), um diesen in Reaktion auf zumindest ein entsprechendes Steuersignal selektiv zu aktivieren oder zu deaktivieren;
**dadurch gekennzeichnet, dass**
die Schaltung einen ersten Schalter (S1) und einen davon unabhängig schaltbaren zweiten Schalter (S2) sowie zumindest einen Prüfsignalausgang (5) zur Bereitstellung eines Prüfsignals zum Prüfen eines aktuellen Betriebszustands des Signalgebers (4) aufweist; und
wobei die Schaltung so konfiguriert ist, dass zur Aktivierung des Signalgebers (4) der erste und der zweite Schalter (S1; S2) zusammen eine spezielle vorbestimmte Schaltzustandskombination aufweisen müssen, während Schaltzustandskombinationen der Schalter, die der speziellen Schaltzustandskombination des ersten und des zweiten Schalters (S1; S2) nicht entsprechen oder diese beinhalten, zu einer Deaktivierung des Signalgebers (4) korrespondieren.

2. Fahrzeugzustandssignalisierungsvorrichtung (2) nach Anspruch 1, wobei:
die Schaltung einen Spannungsteiler mit zwei in Reihe geschalteten Zweipolen aufweist, und der Prüfsignalausgang (5) von einem zwischen den beiden Zweipolen gelegenen Schaltungspunkt ausgeht;
in einem ersten der Zweipole der erste und der zweite Schalter (S1; S2) angeordnet sind und in dem zweiten der Zweipole der Signalgeber (4) angeordnet ist; und
der Signalgeber (4) nur dann mittels einer über dem Spannungsteiler angelegten Betriebsspannung aktiviert werden kann, wenn sich der erste und der zweite Schalter (S1; S2) zugleich jeweils im geschlossenen Schaltzustand befinden.

3. Fahrzeugzustandssignalisierungsvorrichtung (2) nach Anspruch 1, wobei:
die Schaltung einen Spannungsteiler mit zwei in Reihe geschalteten Zweipolen aufweist, und der Prüfsignalausgang (5) von einem zwischen den beiden Zweipolen gelegenen Schaltungspunkt ausgeht;
in einem ersten der Zweipole der erste Schalter (S1) angeordnet ist und in dem zweiten der Zweipole der Signalgeber (4) und der zweite Schalter (S2) angeordnet sind; und
der Signalgeber (4) nur dann mittels einer über dem Spannungsteiler angelegten Betriebsspannung aktiviert werden kann, wenn sich der erste und der zweite Schalter (S1; S2) zugleich jeweils im geschlossenen Schaltzustand befinden.

4. Fahrzeugzustandssignalisierungsvorrichtung (2) nach Anspruch 3, wobei:
in dem zweiten Zweipol der zweite Schalter (S2) parallel zu dem Signalgeber (4) geschaltet ist; und
der Signalgeber (4) nur dann mittels einer über dem Spannungsteiler angelegten Betriebsspannung aktiviert werden kann, wenn sich der erste Schalter (S1) im geschlossenen Schaltzustand befindet und sich zugleich der zweite Schalter (S2) im geöffneten Schaltzustand befindet.

5. Fahrzeugzustandssignalisierungsvorrichtung (2) nach einem der Ansprüche 2 bis 4, wobei der Spannungsteiler ein belasteter Spannungsteiler ist, bei dem der zweite Zweipol eine parallel zu dem Signalgeber (4) geschalteten Last (R2) aufweist.

6. System (1) zur überwachten Fahrzeugzustandssignalisierung, insbesondere einer Signalisierung eines aktivierten zumindest teilautomatisierten Fahrbetriebszustands eines Kraftfahrzeugs, wobei das System (1) eine Überwachungsvorrichtung (3) sowie eine damit signalverbundene Fahrzeugzustandssignalisierungsvorrichtung (2) nach einem der Ansprüche 1 bis 5 aufweist, wobei die Überwachungsvorrichtung derart konfiguriert ist, so dass:
ein erstes Steuersignal an die Fahrzeugzustandssignalisierungsvorrichtung (2) übermittelbar ist, so dass der zugeordnete Signalgeber (4) der Fahrzeugzustandssignalisierungsvorrichtung (2) in einen deaktivierten Zustand versetzbar ist;
nachfolgend einaktueller tatsächlicher Betriebszustands des Signalgebers (4) prüfbar ist; und
falls die Prüfung ergibt, dass sich der Signalgeber (4) trotz des übermittelten Steuersignals in einem aktivierten Betriebszustand befindet, zumindest eine vorbestimmte und diesem Prüfungsergebnis zugeordnete Fehlerbegegnungsaktion auslösbar ist, wobei die Überwachungsvorrichtung (3) eine Prüfvorrichtung aufweist, die eingerichtet ist, ein an einem Prüfsignalausgang (5) der Fahrzeugzustandssignalisierungsvorrichtung (2) ausgegebenes Prüfsignal (PS) zu prüfen, um auf Basis der Prüfung einen aktuellen Betriebszustand des Signalgebers (4) der Fahrzeugzustandssignalisierungsvorrichtung (2) zu bestimmen.

7. System (1) nach Anspruch 6, wobei:
das System (1) auf zwei oder mehr verschiedene Geräte (2a, 2b) aufgeteilt ist;
der erste Schalter (S1) und der zweite Schalter (S2) der Fahrzeugzustandssignalisierungsvorrichtung (2) in zwei verschiedenen der Geräte (2a, 2b) angeordnet sind; und
der Prüfsignalausgang (5) der Fahrzeugzustandssignalisierungsvorrichtung (2) zu zumindest zwei der Geräte (2a, 2b) geführt ist und diese zumindest zwei Geräte (2a, 2b) jeweils eingerichtet sind, die folgenden Verfahrensschritte einzeln oder kumulativ miteinander in Bezug auf die Fahrzeugzustandssignalisierungsvorrichtung (2) des Systems (1) auszuführen:
- Übermitteln eines ersten Steuersignals an die Fahrzeugzustandssignalisierungsvorrichtung (2), das konfiguriert ist, einen zugeordneten Signalgeber (4) der Fahrzeugzustandssignalisierungsvorrichtung (2) in einen deaktivierten Zustand zu versetzen; nachfolgendes Prüfen eines aktuellen tatsächlichen Betriebszustands des Signalgebers (4); und falls die Prüfung ergibt, dass sich der Signalgeber (4) trotz des übermittelten Steuersignals in einem aktivierten Betriebszustand befindet, Auslösen zumindest einer vorbestimmten und diesem Prüfungsergebnis zugeordneten Fehlerbegegnungsaktion,
- wobei die Fehlerbegegnungsaktion das Ausgeben eines vom ersten Steuersignal unabhängigen zweiten Steuersignals umfasst, das konfiguriert ist, zumindest einen der folgenden Prozesse auszulösen: Überführen der Fahrzeugzustandssignalisierungsvorrichtung (2) in einen sicheren Zustand; Ausgeben einer Fehlermeldung an einer Mensch-Maschine-Schnittstelle (7),
- wobei das zweiten Steuersignal konfiguriert ist, die Fahrzeugzustandssignalisierungsvorrichtung (2) zu veranlassen, mittels Selbstdeaktivierung insgesamt oder mittels selektivem Deaktivieren ihres betroffenen Signalgebers (4) in einen sicheren Zustand überzugehen,
- wobei das Verfahren wiederholt oder in Abhängigkeit von dem der Fahrzeugzustandssignalisierungsvorrichtung (2) insgesamt oder einem individuell dem Signalgeber (4) zugeordneten Fahrzeugzustand durchgeführt wird,
- wobei die Fahrzeugzustandssignalisierungsvorrichtung (2) eine Mehrzahl von sich untereinander zumindest in einem Signalisierungsaspekt unterscheidenden Signalgebern (4R, 4G, 4B) aufweist und das Verfahren selektiv nur bezüglich einer ersten echten Untermenge der Signalgeber (4R, 4G, 4B) der Fahrzeugzustandssignalisierungsvorrichtung (2) individuell je Signalgeber (4R, 4G, 4B) oder bezüglich einer oder mehrerer vorbestimmter Kombinationen von Signalgebern (4R, 4G, 4B) aus der Untermenge ausgeführt wird.

8. System (1) nach Anspruch 6 oder 7, wobei:
die Fahrzeugzustandssignalisierungsvorrichtung (2) eine Mehrzahl von sich untereinander zumindest in einem Signalisierungsaspekt unterscheidenden Signalgebern (4R, 4G, 4B) aufweist; und
die Überwachungsvorrichtung (3) eingerichtet ist, bezüglich der Fahrzeugzustandssignalisierungsvorrichtung (2) den folgenden Verfahrensschritt selektiv für jeden der Signalgeber (4R, 4G, 4B) individuell auszuführen, wonach die Fahrzeugzustandssignalisierungsvorrichtung (2) eine Mehrzahl von sich untereinander zumindest in einem Signalisierungsaspekt unterscheidenden Signalgebern (4R, 4G, 4B) aufweist und das Verfahren selektiv nur bezüglich einer ersten echten Untermenge der Signalgeber (4R, 4G, 4B) der Fahrzeugzustandssignalisierungsvorrichtung (2) individuell je Signalgeber (4R, 4G, 4B) oder bezüglich einer oder mehrerer vorbestimmter Kombinationen von Signalgebern (4R, 4G, 4B) aus der Untermenge ausgeführt wird.

9. System (1) nach Anspruch 8, wobei das System (1) konfiguriert ist, in dem Fall, dass die Prüfung bezüglich eines der Signalgeber (4R, 4G, 4B) ergibt, dass sich dieser Signalgeber (4R, 4G, 4B) trotz des entsprechenden übermittelten Steuersignals in einem aktivierten Betriebszustand befindet, selektiv diesen Signalgeber (4R, 4G, 4B) zu deaktivieren.

10. Fahrzeug, insbesondere Kraftfahrzeug, aufweisend ein System (1) nach einem der Ansprüche 6 bis 9.

## Claims

1. Vehicle state signalling device (2), in particular device for signalling an activated at least partially automated driving operational state of a motor vehicle, having:
a signal generator (4) which is configured to output a state signal for signalling a vehicle state assigned to the signal generator (4); and
a circuit for controlling the signal generator (4) in order to selectively activate or deactivate the latter in response to at least one corresponding control signal;
**characterized in that**
the circuit has a first switch (S1) and a second switch (S2) that can be switched independently of the latter as well as at least one test signal output (5) for providing a test signal for testing a current operational state of the signal generator (4); and
wherein the circuit is configured such that, in order to activate the signal generator (4), the first and second switches (S1; S2) must together have a special predetermined switching state combination, whereas switching state combinations of the switches which do not correspond to or comprise the special switching state combination of the first and second switches (S1; S2) correspond to deactivation of the signal generator (4).

2. Vehicle state signalling device (2) according to Claim 1, wherein:
the circuit has a voltage divider with two two-terminal networks connected in series, and the test signal output (5) starts from a circuit point between the two two-terminal networks;
the first and second switches (S1; S2) are arranged in a first of the two-terminal networks and the signal generator (4) is arranged in the second of the two-terminal networks; and
the signal generator (4) can be activated by means of an operating voltage applied across the voltage divider only when the first and second switches (S1; S2) are each in the closed switching state at the same time.

3. Vehicle state signalling device (2) according to Claim 1, wherein:
the circuit has a voltage divider with two two-terminal networks connected in series, and the test signal output (5) starts from a circuit point between the two two-terminal networks;
the first switch (S1) is arranged in a first of the two-terminal networks and the signal generator (4) and the second switch (S2) are arranged in the second of the two-terminal networks; and
the signal generator (4) can be activated by means of an operating voltage applied across the voltage divider only when the first and second switches (S1; S2) are each in the closed switching state at the same time.

4. Vehicle state signalling device (2) according to Claim 3, wherein:
the second switch (S2) is connected in parallel with the signal generator (4) in the second two-terminal network; and
the signal generator (4) can be activated by means of an operating voltage applied across the voltage divider only when the first switch (S1) is in the closed switching state and the second switch (S2) is in the open switching state at the same time.

5. Vehicle state signalling device (2) according to one of Claims 2 to 4, wherein the voltage divider is a loaded voltage divider in which the second two-pole network has a load (R2) connected in parallel with the signal generator (4).

6. System (1) for monitored vehicle state signalling, in particular signalling an activated at least partially automated driving operational state of a motor vehicle, wherein the system (1) has a monitoring device (3) and a vehicle state signalling device (2) according to one of Claims 1 to 5 which has a signal connection thereto, wherein the monitoring device is configured such that:
a first control signal can be transmitted to the vehicle state signalling device (2), with the result that the assigned signal generator (4) of the vehicle state signalling device (2) can be changed to a deactivated state;
a current actual operational state of the signal generator (4) can then be tested; and
if the test reveals that the signal generator (4) is in an activated operational state despite the transmitted control signal, at least one predetermined fault remedying action assigned to this test result can be initiated, wherein the monitoring device (3) has a test device which is configured to test a test signal (PS) output at a test signal output (5) of the vehicle state signalling device (2) in order to determine a current operational state of the signal generator (4) of the vehicle state signalling device (2) on the basis of the test.

7. System (1) according to Claim 6, wherein:
the system (1) is divided among two or more different devices (2a, 2b);
the first switch (S1) and the second switch (S2) of the vehicle state signalling device (2) are arranged in two different ones of the devices (2a, 2b); and
the test signal output (5) of the vehicle state signalling device (2) is routed to at least two of the devices (2a, 2b) and these at least two devices (2a, 2b) are each configured to carry out the following method steps individually or cumulatively with one another with respect to the vehicle state signalling device (2) of the system (1):
- transmitting a first control signal to the vehicle state signalling device (2), which control signal is configured to change an assigned signal generator (4) of the vehicle state signalling device (2) to a deactivated state; subsequently testing a current actual operational state of the signal generator (4); and, if the test reveals that the signal generator (4) is in an activated operational state despite the transmitted control signal, initiating at least one predetermined fault remedying action assigned to this test result,
- wherein the fault remedying action comprises outputting a second control signal which is independent of the first control signal and is configured to initiate at least one of the following processes: transferring the vehicle state signalling device (2) to a safe state; outputting a fault message at a man-machine interface (7),
- wherein the second control signal is configured to cause the vehicle state signalling device (2) to change to a safe state by means of self-deactivation overall or by selectively deactivating its affected signal generator (4),
- wherein the method is carried out repeatedly or on the basis of the vehicle state assigned to the vehicle state signalling device (2) overall or a vehicle state individually assigned to the signal generator (4),
- wherein the vehicle state signalling device (2) has a plurality of signal generators (4R, 4G, 4B) which differ from one another at least in a signalling aspect, and the method is carried out selectively only with respect to a first true subset of the signal generators (4R, 4G, 4B) of the vehicle state signalling device (2), individually for each signal generator (4R, 4G, 4B), or with respect to one or more predetermined combinations of signal generators (4R, 4G, 4B) from the subset.

8. System (1) according to Claim 6 or 7, wherein:
the vehicle state signalling device (2) has a plurality of signal generators (4R, 4G, 4B) which differ from one another at least in a signalling aspect; and
the monitoring device (3) is configured to individually carry out the following method step selectively for each of the signal generators (4R, 4G, 4B) with respect to the vehicle state signalling device (2), after which the vehicle state signalling device (2) has a plurality of signal generators (4R, 4G, 4B) which differ from one another at least in a signalling aspect, and the method is carried out selectively only with respect to a first true subset of the signal generators (4R, 4G, 4B) of the vehicle state signalling device (2), individually for each signal generator (4R, 4G, 4B), or with respect to one or more predetermined combinations of signal generators (4R, 4G, 4B) from the subset.

9. System (1) according to Claim 8, wherein the system (1) is configured, if the test with respect to one of the signal generators (4R, 4G, 4B) reveals that this signal generator (4R, 4G, 4B) is in an activated operational state despite the corresponding transmitted control signal, to selectively deactivate this signal generator (4R, 4G, 4B).

10. Vehicle, in particular motor vehicle, having a system (1) according to one of Claims 6 to 9.

## Revendications

1. Dispositif de signalisation d'état de véhicule (2), en particulier dispositif destiné à signaler un état de fonctionnement pendant le roulement activé, au moins partiellement automatisé, d'un véhicule automobile, ledit dispositif comportant :
un transmetteur de signal (4) qui est configuré pour délivrer un signal d'état destiné à signaler un état de véhicule associé au transmetteur de signal (4) ; et
un circuit de commande du transmetteur de signal (4) pour activer ou désactiver celui-ci sélectivement en réponse à au moins un signal de commande correspondant ;
**caractérisé en ce que**
le circuit comporte un premier commutateur (S1) et un deuxième commutateur (S2), qui peut être commuté indépendamment du premier, et au moins une sortie de signal de test (5) destinée à fournir un signal de test pour tester un état de fonctionnement actuel du transmetteur de signal (4) ; et
le circuit étant configuré de manière à ce que, afin d'activer le transmetteur de signal (4), les premier et deuxième commutateurs (S1 ; S2) doivent présenter conjointement une combinaison d'états de commutation particulière prédéterminée tandis que des combinaisons d'états des commutateurs, qui ne correspondent pas à la combinaison d'états de commutation particulière des premier et deuxième commutateurs (S1 ; S2) ou qui ne la contiennent pas, correspondent à une désactivation du transmetteur de signal (4).

2. Dispositif de signalisation d'état de véhicule (2) selon la revendication 1 :
le circuit comportant un diviseur de tension pourvu de deux dipôles montés en série, et la sortie de signal de test (5) émanant d'un point de circuit situé entre les deux dipôles ;
les premier et deuxième commutateurs (S1 ; S2) étant disposés dans un premier des dipôles et le transmetteur de signal (4) étant disposé dans le deuxième des dipôles ; et
le transmetteur de signal (4) ne pouvant être activé au moyen d'une tension de fonctionnement appliquée aux bornes du diviseur de tension que si les premier et deuxième commutateurs (S1 ; S2) se trouvent tous les deux en même temps dans l'état de commutation fermé.

3. Dispositif de signalisation d'état de véhicule (2) selon la revendication 1 :
le circuit comportant un diviseur de tension pourvu de deux dipôles montés en série, et la sortie de signal de test (5) émanant d'un point de circuit situé entre les deux dipôles ;
le premier commutateur (S1) étant disposé dans un premier des dipôles et le transmetteur de signal (4) et
le deuxième commutateur (S2) étant disposés dans le deuxième des dipôles ; et
le transmetteur de signal (4) ne pouvant être activé au moyen d'une tension de fonctionnement appliquée aux bornes du diviseur de tension que si les premier et deuxième commutateurs (S1 ; S2) se trouvent tous les deux en même temps dans l'état de commutation fermé.

4. Dispositif de signalisation d'état de véhicule (2) selon la revendication 3 :
le deuxième commutateur (S2) étant monté en parallèle avec le transmetteur de signal (4) dans le deuxième dipôle ; et
le transmetteur de signal (4) ne pouvant être activé au moyen d'une tension de fonctionnement appliquée aux bornes du diviseur de tension que lorsque le premier commutateur (S1) se trouve dans l'état de commutation fermé et que le deuxième commutateur (S2) se trouve en même temps dans l'état de commutation ouvert.

5. Dispositif de signalisation d'état de véhicule (2) selon l'une des revendications 2 à 4, le diviseur de tension étant un diviseur de tension chargé dans lequel le deuxième dipôle a une charge (R2) montée en parallèle avec le transmetteur de signal (4).

6. Système (1) de signalisation d'état de véhicule surveillé, en particulier de signalisation d'un état de fonctionnement pendant le roulement activé, au moins partiellement automatisé, d'un véhicule automobile, le système (1) comportant un dispositif de surveillance (3) et un dispositif de signalisation d'état de véhicule (2) relié à celui-ci par signal selon l'une des revendications 1 à 5, le dispositif de surveillance étant configuré de manière à ce que :
un premier signal de commande puisse être transmis au dispositif de signalisation d'état de véhicule (2) de sorte que le transmetteur de signal associé (4) du dispositif de signalisation d'état de véhicule (2) puisse être mis dans un état désactivé ;
puis, un état de fonctionnement réel actuel du transmetteur de signal (4) puisse être testé ; et
si le test révèle que le transmetteur de signal (4) se trouve dans un état de fonctionnement activé malgré le signal de commande transmis, au moins une action de survenance d'erreur prédéterminée associée à ce résultat de test puisse être déclenchée, le dispositif de surveillance (3) comportant un dispositif de test qui est conçu pour tester un signal de test (PS), délivré à une sortie de signal de test (5) du dispositif de signalisation d'état de véhicule (2), afin de déterminer un état de fonctionnement actuel du transmetteur de signal (4) du dispositif de signalisation d'état de véhicule (2) sur la base du test.

7. Système (1) selon la revendication 6 :
le système (1) étant divisé en deux ou plusieurs unités différentes (2a, 2b) ; le premier commutateur (S1) et
le deuxième commutateur (S2) du dispositif de signalisation d'état de véhicule (2) étant disposés dans deux unités différentes des unités (2a, 2b) ; et
la sortie de signal de test (5) du dispositif de signalisation d'état de véhicule (2) étant acheminée vers au moins deux des unités (2a, 2b) et ces au moins deux unités (2a, 2b) étant chacune conçues pour réaliser les étapes de procédé suivantes individuellement ou cumulativement les unes avec les autres en relation avec le dispositif de signalisation d'état de véhicule (2) du système (1) :
- transmettre au dispositif de signalisation d'état de véhicule (2) un premier signal de commande qui est configuré pour mettre un transmetteur de signal associé (4) du dispositif de signalisation d'état de véhicule (2) dans un état désactivé ; tester ensuite un état de fonctionnement réel actuel du transmetteur de signal (4) ; et, si le test révèle que le transmetteur de signal (4) se trouve dans un état de fonctionnement activé malgré le signal de commande transmis, déclencher au moins une action de survenance d'erreur prédéterminée associée à ce résultat de test,
- l'action de survenance d'erreur comprenant la délivrance d'un deuxième signal de commande qui est indépendant du premier signal de commande et qui est configuré pour déclencher l'un au moins des processus suivants : passage du dispositif de signalisation d'état de véhicule (2) dans un état sûr ; délivrance d'un message d'erreur au niveau d'une interface hommemachine (7),
- le deuxième signal de commande étant configuré pour amener le dispositif de signalisation d'état de véhicule (2) dans un état sûr au moyen d'une autodésactivation totale ou d'une désactivation sélective de son transmetteur de signal associé (4),
- le procédé étant mis en œuvre de manière répétée ou en fonction d'un état de véhicule associé au dispositif de signalisation d'état de véhicule (2) dans son ensemble ou d'un état de véhicule associé individuellement au transmetteur de signal (4),
- le dispositif de signalisation d'état de véhicule (2) comportant une pluralité de transmetteurs de signal (4R, 4G, 4B) qui diffèrent les uns des autres au moins par un aspect de signalisation, et le procédé n'étant mis en œuvre sélectivement que par rapport à un premier sous-ensemble réel de transmetteurs de signal (4R, 4G, 4B) du dispositif de signalisation d'état de véhicule (2) individuellement pour chaque transmetteur de signal (4R, 4G, 4B) ou par rapport à une ou plusieurs combinaisons prédéterminées de transmetteurs de signal (4R, 4G, 4B) du sous-ensemble.

8. Système (1) selon la revendication 6 ou 7 :
le dispositif de signalisation d'état de véhicule (2) comportant une pluralité de transmetteurs de signal (4R, 4G, 4B) qui diffèrent les uns des autres au moins par un aspect de signalisation ; et
le dispositif de surveillance (3) étant conçu pour réaliser individuellement, par rapport au dispositif de signalisation d'état de véhicule (2), l'étape de procédé suivante sélectivement pour chacun des transmetteurs de signal (4R, 4G, 4B), après quoi le dispositif de signalisation d'état de véhicule (2) comportant une pluralité de transmetteurs de signal (4R, 4G, 4B) et le procédé n'étant mis en œuvre sélectivement que par rapport à un premier sous-ensemble réel de transmetteurs de signal (4R, 4G, 4B) du dispositif de signalisation d'état de véhicule (2) individuellement pour chaque transmetteur de signal (4R, 4G, 4B) ou par rapport à une ou plusieurs combinaisons prédéterminées de transmetteurs de signal (4R, 4G, 4B) du sous-ensemble.

9. Système (1) selon la revendication 8, le système (1) étant configuré, dans le cas où le test par rapport à l'un des transmetteurs de signal (4R, 4G, 4B) montre que ce transmetteur de signal (4R, 4G, 4B) se trouve dans un état de fonctionnement activé malgré le signal de commande transmis correspondant, pour désactiver sélectivement ce transmetteur de signal (4R, 4G, 4B).

10. Véhicule, notamment véhicule automobile, comportant un système (1) selon l'une des revendications 6 à 9.
